# EUROPEAN PATENT APPLICATION

(11) **EP 4 686 329 A1**
(43) Date of publication of application: **28.01.2026**
(21) Application number: 24800150.5
(22) Date of filing: 08.03.2024
(51) Int. Cl.: H05K 7/20, G02B 27/01

(54) **ELECTRONIC DEVICE COMPRISING STRUCTURE FOR DISSIPATING HEAT TO OUTSIDE**

(30) Priority: 04.05.2023 KR 20230058244; 04.07.2023 KR 20230086763
(71) Applicant: Samsung Electronics Co., Ltd., Suwon-si, Gyeonggi-do 16677 (KR)
(72) Inventor: LEE, Sengtai, Suwon-si Gyeonggi-do 16677 (KR); KIM, Kwangtai, Suwon-si Gyeonggi-do 16677 (KR); KIM, Seungnyun, Suwon-si Gyeonggi-do 16677 (KR); KIM, Wook, Suwon-si Gyeonggi-do 16677 (KR); KIM, Joonhyoung, Suwon-si Gyeonggi-do 16677 (KR); YOON, Jongmin, Suwon-si Gyeonggi-do 16677 (KR)
(74) Representative: HGF
(86) International application number: PCT/KR2024/003048
(87) International publication number: WO 2024/228462

(57) **Abstract**

An electronic device is provided. The electronic device comprises: a housing including an inlet and an outlet spaced apart from the inlet; a printed circuit board including one surface and electronic components arranged on the one surface; at least one fan which generate airflow and which is arranged inside the housing so as to cool the electronic components; and a guide member which has at least a part arranged inside the outlet and which guides the airflow, wherein, when the housing rotates in a first rotation direction, the guide member can rotate with respect to the housing in a second rotation direction, which is opposite to the first rotation direction.

## Description

### [Technical Field]

The present disclosure relates to an electronic device including a structure for dissipating heat to the outside.

### [Background Art]

An electronic device may include various electronic components to meet a demand of a user. As the electronic device operates, the electronic components in the electronic device may generate heat. The electronic device may include components for dissipating the heat in the electronic device to the outside of the electronic device.

The above-described information may be provided as a related art for the purpose of helping understanding of the present disclosure. No argument or decision is made as to whether any of the above description may be applied as a prior art related to the present disclosure.

### [Disclosure]

### [Technical Solution]

An electronic device is provided. The electronic device may comprise a housing including an inlet and an outlet spaced apart from the inlet. The electronic device may comprise a printed circuit board (PCB) including a first surface and an electronic component disposed on the first surface. The electronic device may comprise at least one fan, configured to generate airflow for discharging air introduced through the inlet to the outside of the housing through the outlet, disposed in the housing for cooling the electronic component. The electronic device may comprise a guide member configured to guide the airflow, wherein at least a portion of the guide member is disposed in the outlet. The guide member may be rotatable, when the housing is rotated in a first rotational direction, in a second rotational direction opposite to the first rotational direction.

An electronic device is provided. The electronic device may comprise a housing including an inlet and an outlet spaced apart from the inlet. The electronic device may comprise a printed circuit board (PCB) including a first surface and an electronic component disposed on the first surface. The electronic device may comprise at least one fan, configured to generate airflow for discharging air introduced through the inlet to the outside of the housing through the outlet, disposed on the first surface, and is spaced apart in a first direction from the outlet. The electronic device may comprise a guide member configured to guide the airflow by being disposed in the outlet and being rotatably coupled to the housing. The guide member may be rotatable with respect to the housing so as to be inclined with respect to the first direction when the housing rotates.

### [Description of the Drawings]

FIG. 1 is a block diagram of an electronic device in a network environment according to various embodiments.
FIG. 2A is a perspective view of an electronic device according to an exemplary embodiment.
FIG. 2B is an exploded perspective view of an electronic device according to an exemplary embodiment.
FIG. 2C is a partial cross-sectional view illustrating an example of an electronic device cut along line A-A' of FIG. 2A according to an exemplary embodiment.
FIG. 3A indicates an example of a state in which an electronic device according to an exemplary embodiment is worn by a user.
FIG. 3B is an exploded perspective view of an electronic device according to an exemplary embodiment.
FIG. 4A is a cross-sectional view illustrating an example of cutting an electronic device according to an exemplary embodiment.
FIG. 4B is a cross-sectional view illustrating an example of cutting an electronic device according to an exemplary embodiment.
FIG. 5A is an exploded perspective view of an electronic device according to an exemplary embodiment.
FIG. 5B is a cross-sectional view illustrating an example of cutting an electronic device according to an exemplary embodiment.
FIG. 5C is a cross-sectional view illustrating an example of cutting an electronic device according to an exemplary embodiment.
FIG. 6A is an enlarged perspective view of an electronic device according to an exemplary embodiment.
FIG. 6B is a cross-sectional view illustrating an example of an electronic device according to an exemplary embodiment cut along line B-B' of FIG. 6A.
FIG. 6C is a cross-sectional view illustrating an example of cutting an electronic device according to an exemplary embodiment.

### [Mode for Invention]

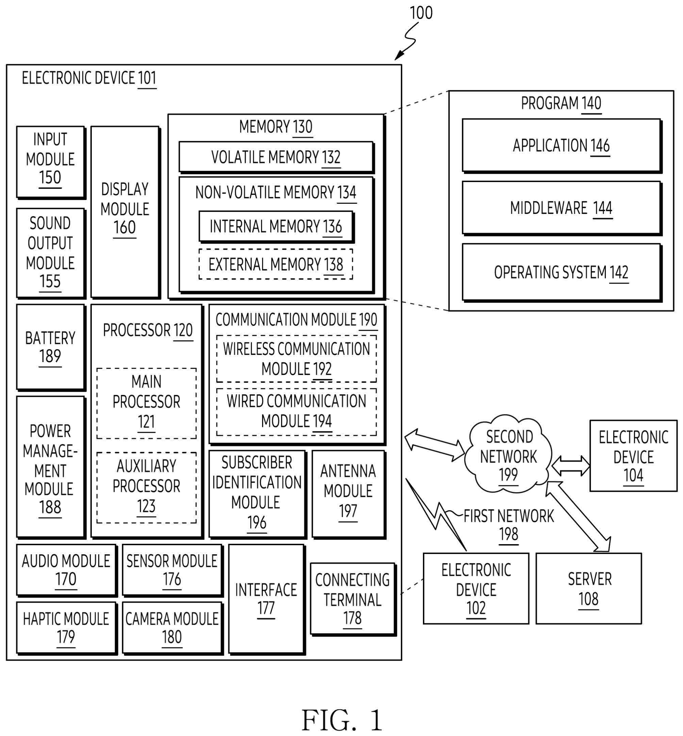

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

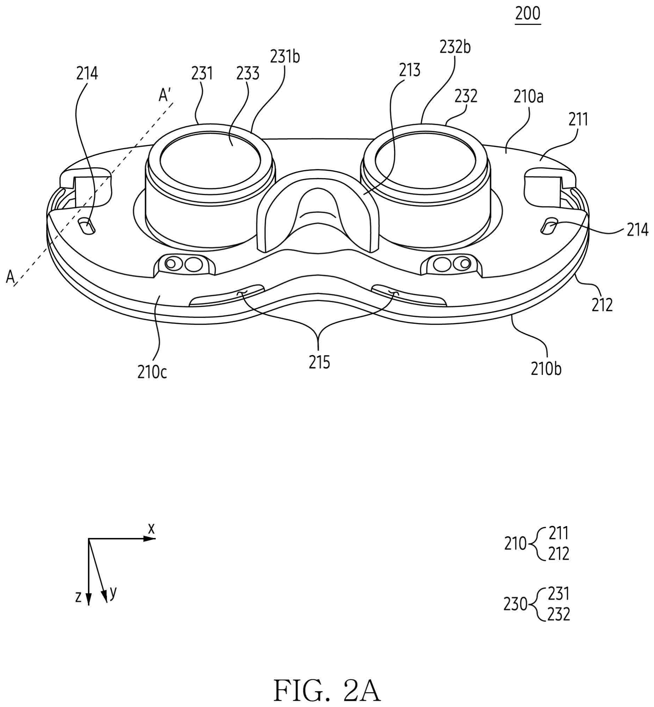

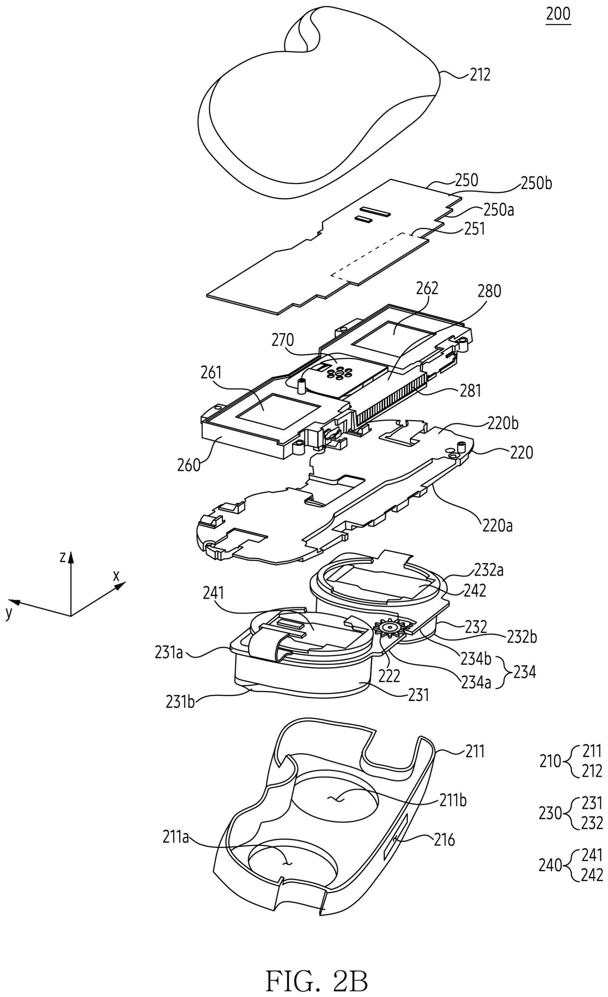

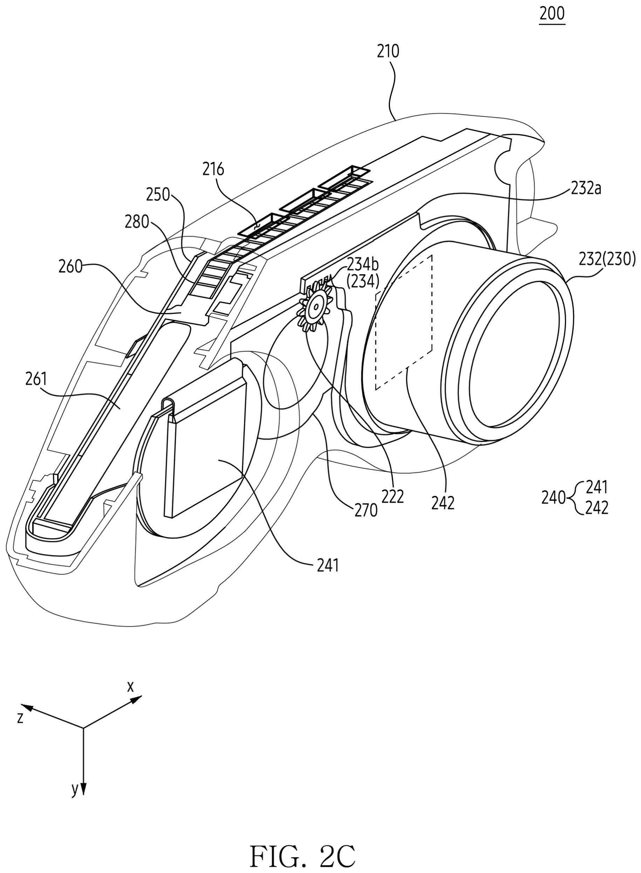

FIG. 2A is a perspective view of an electronic device according to an exemplary embodiment, FIG. 2B is an exploded perspective view of an electronic device according to an exemplary embodiment, and FIG. 2C is a partial cross-sectional view illustrating an example of an electronic device cut along line A-A' of FIG. 2A according to an exemplary embodiment.

Referring to FIGS. 2A, 2B, and 2C, an electronic device 200 (e.g., the electronic device 101 of FIG. 1) according to an embodiment may include a housing 210, a first bracket 220, at least one moving flange 230, at least one display 240, a printed circuit board 250, a second bracket 260, at least one fan 270, and/or a heat dissipation member 280. According to an embodiment, the electronic device 200 may be referred to as a wearable device worn on a portion of a body of a user. The electronic device 200 may be configured to provide augmented reality (AR), virtual reality (VR), or mixed reality (MR) in which the augmented reality and the virtual reality are mixed to the user. For example, the electronic device 200 may be configured to provide the virtual reality through the at least one display 240, based on receiving data on an image from the outside of the electronic device 200. For example, the image provided by the electronic device 200 may include a still image and a video for implementing the virtual reality. For example, the electronic device 200 may be configured to provide the augmented reality by displaying a screen in which a virtual object is superimposed on a reality image provided by light received from the outside of the electronic device 200 on the at least one display 240. The reality image may mean an image or a video implemented by the light received from the outside of the electronic device 200 without separate data processing by the electronic device 200. The virtual object may include at least one of text and an image corresponding to various information related to an object included in the reality image. However, it is not limited thereto, and the virtual object may include at least one of text and an image corresponding to various information related to another object distinguished from the object included in the reality image.

The housing 210 may define at least a portion of an outer surface of the electronic device 200. The housing 210 may accommodate various components of the electronic device 200. The housing 210 may surround various components of the electronic device 200. According to an embodiment, when the electronic device 200 is worn by the user, a first surface 210a of the housing 210 may face a portion of the body of the user. For example, the housing 210 may include the first surface 210a, a second surface 210b, and/or a lateral surface 210c. When the electronic device 200 is worn on a head, the first surface 210a of the housing 210 may face a face of the user. The second surface 210b of the housing 210 may be opposite to the first surface 210a of the housing 210. The second surface 210b may be spaced apart from the first surface 210a. A direction (e.g., a +z direction) in which the second surface 210b faces may be opposite to a direction (e.g., a -z direction) in which the first surface 210a faces. For example, the direction in which the second surface 210b faces may be substantially parallel to a gaze direction of the user when the electronic device 200 is worn on the user. According to an embodiment, the lateral surface 210c of the housing 210 may connect the first surface 210a and the second surface 210b. The lateral surface 210c may extend from the first surface 210a to the second surface 210b. The lateral surface 210c may surround a periphery of the first surface 210a and a periphery of the second surface 210b. According to an embodiment, the lateral surface 210c of the housing 210 may be bent with a curvature, but it is not limited thereto. For example, the lateral surface 210c may be substantially perpendicular to the first surface 210a and the second surface 210b.

According to an embodiment, the housing 210 may include a first case 211 and a second case 212. The first case 211 and the second case 212 may define (or form) the housing 210 by being coupled to each other. The first case 211 may define the first surface 210a of the housing 210. According to an embodiment, the first case 211 may include a first driving hole 211a and a second driving hole 211b. The first driving hole 211a and the second driving hole 211b may define (or form or provide) a space in which the at least one moving flange 230 may move. For example, the first driving hole 211a may define a space in which a first moving flange 231 may move. For example, the second driving hole 211b may define a space in which a second moving flange 232 may move. According to an embodiment, the first driving hole 211a and the second driving hole 211b may penetrate the first case 211. The first driving hole 211a and the second driving hole 211b may be spaced apart from each other. According to an embodiment, sizes of each of the first driving hole 211a and the second driving hole 211b may be larger than sizes of each of the first moving flange 231 and the second moving flange 232. For example, a cross-sectional area of each of the first driving hole 211a and the second driving hole 211b may be larger than a size of a cross-sectional area of each of the first moving flange 231 and the second moving flange 232. The second case 212 may define the second surface 210b of the housing 210. According to an embodiment, the lateral surface 210c of the housing 210 may be defined (or formed) by coupling of the first case 211 and the second case 212.

According to an embodiment, the housing 210 may include a nose pad 213. The nose pad 213 may support the electronic device 200 by bonding to a portion of the body of the user when the electronic device 200 is worn on the user. The nose pad 213 may have a shape corresponding to the shape of the portion of the body of the user. For example, the nose pad 213 may be contacted with a nose of the user when electronic device 200 is worn on the head of the user. According to an embodiment, a shape of the electronic device 200 may be substantially symmetrical with respect to the nose pad 213.

According to an embodiment, the housing 210 may include at least one first inlet 214, at least one second inlet 215, and at least one outlet 216. The at least one first inlet 214 may connect the outside of the housing 210 and the inside of the housing 210. The at least one first inlet 214 may transfer air from the outside of the housing 210 to the inside of the housing 210. According to an embodiment, the at least one first inlet 214 may penetrate the first surface 210a of the housing 210. The at least one first inlet 214 may be formed on the first surface 210a. The number of the at least one first inlet 214 may be one or more. The at least one second inlet 215 may connect the outside of the housing 210 and the inside of the housing 210. The at least one second inlet 215 may transmit air from the outside of the housing 210 to the inside of the housing 210. According to an embodiment, the at least one second inlet 215 may penetrate the lateral surface 210c of the housing 210. The at least one second inlet 215 may be formed on the lateral surface 210c. The number of the at least one second inlet 215 may be one or more. The at least one outlet 216 may connect the outside of the housing 210 and the inside of the housing 210. The at least one outlet 216 may transmit air from the inside of the housing 210 to the outside of the housing 210. For example, the at least one outlet 216 may transfer air that has passed through the heat dissipation member 280 to the outside of the housing 210. According to one embodiment, at least a portion of the at least one outlet 216 may be superimposed on the heat dissipation member 280 when viewed from above. For example, the at least one outlet 216 may penetrate the lateral surface 210c of the housing 210. For example, the at least one outlet 216 may be formed on the lateral surface 210c of the housing 210. The number of the at least one outlet 216 may be one or more.

The first bracket 220 may support a portion of the components of the electronic device 200 within the housing 210. According to an embodiment, the first bracket 220 may be disposed in the housing 210. For example, the first bracket 220 may be disposed between the at least one moving flange 230 and the second bracket 260. According to an embodiment, a surface 220a of the first bracket 220 may face the at least one display 240. Another surface 220b of the first bracket 220 may be opposite to the surface 220a of the first bracket 220. A direction (e.g., the +z direction) in which the other surface 220b of the first bracket 220 faces may be opposite to a direction (e.g., the -z direction) in which the surface 220a of the first bracket 220 faces. The other surface 220b of the first bracket 220 may be spaced apart from the surface 220a of the first bracket 220.

According to an embodiment, the electronic device 200 may include a pinion gear 222 coupled to the first bracket 220. The pinion gear 222 may be rotatable with respect to the first bracket 220. The pinion gear 222 may include a plurality of gear teeth. The pinion gear 222 may be disposed on the surface 220a of the first bracket 220. When an element is referred to as being "on" another element, it is to be understood that the element may be directly on the other element, or intervening elements may be present therebetween. In contrast, when an element is referred to as being "directly on" another element, no intervening elements are present.

The at least one moving flange 230 may be coupled to the housing 210 to be movable with respect to the housing 210. For example, the at least one moving flange 230 may be movable with respect to the first bracket 220 in the housing 210. According to an embodiment, the at least one moving flange 230 may include the first moving flange 231 and the second moving flange 232. The first moving flange 231 may pass through the first driving hole 211a. For example, the first moving flange 231 may pass through the first driving hole 211a by extending from the inside of the housing 210. The second moving flange 232 may pass through the second driving hole 211b. For example, the second moving flange 232 may pass through the second driving hole 211b by extending from the inside of the housing 210. According to an embodiment, a portion of the moving flange 230 may be disposed in the housing 210. For example, the portion of the moving flange 230 may be coupled to the at least one display 240 in the housing 210. For example, a portion 231a of the first moving flange 231 may be coupled to a first display 241 in the housing 210. For example, a portion 232a of the second moving flange 232 may be coupled to a second display 242 within the housing 210. According to an embodiment, the portion of the moving flange 230 may face the first bracket 220. For example, the portion 231a of the first moving flange 231 may face the surface 220a of the first bracket 220. For example, the portion 232a of the second moving flange 232 may face the surface 220a of the first bracket 220. According to an embodiment, another portion of the moving flange 230 may be disposed outside the housing 210. For example, another portion 231b of the first moving flange 231 may be disposed outside the housing 210. For example, another portion 232b of the second moving flange 232 may be disposed outside the housing 210. According to an embodiment, the other portion 231b of the first moving flange 231 may protrude to the outside of the housing 210. For example, the other portion 231b of the first moving flange 231 may pass through the first driving hole 211a. For example, the other portion 231b of the first moving flange 231 may be disposed outside the first driving hole 211a. According to an embodiment, the other portion 232b of the second moving flange 232 may protrude to the outside of the housing 210. For example, the other portion 232b of the second moving flange 232 may pass through the second driving hole 211b. For example, the other portion 232b of the second moving flange 232 may be disposed outside the second driving hole 211b.

According to an embodiment, the at least one moving flange 230 may include a lens 233. The lens 233 may refract light emitted from the at least one display 240 so that the electronic device 200 may provide the virtual reality. According to an embodiment, the lens 233 may be coupled to the other portion of the at least one moving flange 230 disposed outside the housing 210. When the electronic device 200 is worn by the user, the lens 233 may face the body of the user. For example, the lens 233 may face eyes of the user when the electronic device 200 is worn on the head of the user. According to an embodiment, the lens 233 may include a plurality of lenses disposed on each of the first moving flange 231 and the second moving flange 232.

According to an embodiment, the at least one moving flange 230 may include a rack gear 234. The rack gear 234 may include a plurality of gear teeth. The rack gear 234 may be engaged with the pinion gear 222. The plurality of gear teeth of the rack gear 234 may be engaged with the plurality of gear teeth of the pinion gear 222. In an embodiment, the rack gear 234 may be disposed in the housing 210. For example, the rack gear 234 may be disposed on a portion of the at least one moving flange 230. According to an embodiment, the rack gear 234 may include a first rack gear 234a and a second rack gear 234b. The first rack gear 234a may be coupled to the first moving flange 231. The second rack gear 234b may be coupled to the second moving flange 232. According to an embodiment, the rack gear 234 may have a shape extending in a direction (e.g., in a +x direction or a -x direction) parallel to the surface 220a of the first bracket 220. For example, the first rack gear 234a and the second rack gear 234b may be parallel to the surface 220a of the first bracket 220.

The at least one display 240 may be configured to provide visual information. For example, the at least one display 240 may be configured to emit light based on receiving data for displaying an image from a processor (e.g., the processor 120 of FIG. 1). According to an embodiment, the at least one display 240 may be electrically connected to the printed circuit board 250. For example, the at least one display 240 may be electrically connected to the printed circuit board 250 through a flexible printed circuit board. According to an embodiment, the at least one display 240 may be coupled to the at least one moving flange 230. For example, the at least one display 240 may be disposed on a portion of the at least one moving flange 230 disposed in the housing 210. According to an embodiment, the at least one display 240 may include the first display 241 and the second display 242. The first display 241 may be coupled to the first moving flange 231. The first display 241 may be disposed on the surface 220a of the first bracket 220. The first display 241 may be spaced apart from the surface 220a of the first bracket 220. The second display 242 may be coupled to the second moving flange 232. The second display 242 may be disposed on the surface 220a of the first bracket 220. The second display 242 may be spaced apart from the surface 220a of the first bracket 220.

According to an embodiment, the at least one display 240 may be movable in the housing 210. The at least one display 240 may be movable with respect to the first bracket 220. For example, the at least one display 240 may be movable on the surface 220a of the first bracket 220. For example, the at least one display 240 may be movable in a direction parallel to the surface 220a of the first bracket 220. According to an embodiment, the second display 242 may be movable in a direction (e.g., the -x direction) approaching the first display 241 or a direction (e.g., the +x direction) away from the first display 241. According to an embodiment, the at least one display 240 may be movable with respect to the first bracket 220 by movement of the at least one moving flange 230 with respect to the first bracket 220. For example, the user may move the at least one moving flange 230 through the other portion of the at least one moving flange 230 protruding outside the housing 210. According to an embodiment, a distance between the first display 241 and the second display 242 may be reduced or increased by movement of the first moving flange 231 and the second moving flange 232. For example, in a case that the first moving flange 231 moves in a direction (e.g., the +x direction) approaching the second moving flange 232 by an external force of the user, the pinion gear 222 engaged with the first rack gear 234a may rotate. The second rack gear 234b engaged with the pinion gear 222 may move in a direction (e.g., the -x direction) approaching the first moving flange 231 by the rotation of the pinion gear 222. As the first moving flange 231 moves in the direction approaching the second moving flange 232 and the second moving flange 232 moves in the direction approaching the first moving flange 231, the distance between the first display 241 and the second display 242 may decrease. For example, in a case that the first moving flange 231 moves in a direction (e.g., the -x direction) away from the second moving flange 232 by the external force of the user, the pinion gear 222 engaged with the first rack gear 234a may rotate. The second rack gear 234b engaged with the pinion gear 222 may move in a direction (e.g., the +x direction) away from the first moving flange 231 by the rotation of the pinion gear 222. As the first moving flange 231 moves in the direction away from the second moving flange 232 and the second moving flange 232 moves in the direction away from the first moving flange 231, the distance between the first display 241 and the second display 242 may increase. The distance between the first display 241 and the second display 242 may be adjusted to correspond to an inter-pupillary distance of the user, through the at least one moving flange 230. As the distance between the first display 241 and the second display 242 is adjusted to correspond to the inter-pupillary distance of the user, the electronic device 200 may provide a three-dimensional virtual reality to the user.

The printed circuit board 250 may form an electrical connection between the components in the electronic device 200. For example, the printed circuit board 250 may form an electrical connection between electronic components disposed on a surface 250a of the printed circuit board 250 or another surface 250b of the printed circuit board 250 opposite the surface 250a of the printed circuit board 250. The printed circuit board 250 may form an electrical connection between other electronic components disposed outside the printed circuit board 250. The printed circuit board 250 may form an electrical connection between the electronic components (e.g., the processor 120 of FIG. 1) disposed on the surface 250a of the printed circuit board 250 and the other electronic components disposed outside the printed circuit board 250. For example, the printed circuit board 250 may be electrically connected to the at least one display 241. According to an embodiment, the printed circuit board 250 may be disposed in the housing 210. For example, the printed circuit board 250 may be disposed on the other surface 220b of the first bracket 220. For example, the printed circuit board 250 may be spaced apart from the other surface 220b of the first bracket 220 in the direction (e.g., the +z direction) in which the other surface 220b of the first bracket 220 faces. The surface 250a of the printed circuit board 250 may face the second bracket 260.

The second bracket 260 may support another portion of the components of the electronic device 200. For example, the second bracket 260 may support a first battery 261 and a second battery 262. The first battery 261 may be coupled to the second bracket 260. The second battery 262 may be coupled to the second bracket 260 by being spaced apart from the first battery 261. According to an embodiment, the second bracket 260 may surround the first battery 261 and the second battery 262. The first battery 261 and the second battery 262 may be electrically connected to the printed circuit board 250. According to an embodiment, the second bracket 260 may be disposed in the housing 210. For example, the second bracket 260 may be disposed between the printed circuit board 250 and the first bracket 220.

The at least one fan 270 may generate airflow for cooling the housing 210 and components positioned in the housing 210. For example, the at least one fan 270 may generate airflow for introducing air outside the housing 210 into the inlets 214 and 215 of the housing 210. The at least one fan 270 may generate airflow for discharging air inside the housing 210 to the at least one outlet 216 of the housing 210. According to an embodiment, the at least one fan 270 may be electrically connected to the printed circuit board 250. The at least one fan 270 may be electrically connected to at least one of the first battery 261 and the second battery 262. The at least one fan 270 may receive power from the at least one of the first battery 261 and the second battery 262. According to an embodiment, the at least one fan 270 may be coupled to the second bracket 260. For example, the at least one fan 270 may be disposed between the first battery 261 and the second battery 262. The at least one fan 270 may be disposed between the printed circuit board 250 and the first bracket 220. For example, the at least one fan 270 may face the other surface 220b of the first bracket 220.

The heat dissipation member 280 may dissipate heat generated from the printed circuit board 250 to the outside of the housing 210. For example, it may include a plurality of fins 281 for increasing a surface area of the inside of the heat dissipation member 280. According to an embodiment, the heat dissipation member 280 may face the surface 250a of the printed circuit board 250. For example, the heat dissipation member 280 may face a portion (e.g., the processor 120 of FIG. 1) of the electronic components disposed on the surface 250a of the printed circuit board 250. According to an embodiment, an area 251 of the printed circuit board 250 may face the heat dissipation member 280. For example, the area 251 of the printed circuit board 250 may overlap the heat dissipation member 280 when the printed circuit board 250 is viewed vertically (e.g., in the +z direction or the -z direction). According to an embodiment, electronic components having a relatively high calorific value may be disposed in the area 251 of the printed circuit board 250 among a plurality of electronic components disposed on the printed circuit board 250. For example, an electronic component disposed in the first area 251 of the printed circuit board 250 may include the processor 120. As the heat dissipation member 280 faces the area 251 of the printed circuit board 250, the heat generated from the electronic components of the printed circuit board 250 may be easily discharged to the outside of the housing 210.

According to an embodiment, the heat dissipation member 280 may pass the airflow generated by the at least one fan 270. The heat dissipation member 280 may be coupled to the second bracket 260. For example, the heat dissipation member 280 may be disposed between the first battery 261 and the second battery 262. According to an embodiment, at least a portion of the heat dissipation member 280 may overlap with the at least one fan 270 when the housing 210 is viewed from above (e.g., a -y direction).

According to an embodiment, air outside the housing 210 may be introduced into the housing 210 through the inlets 214 and 215 by the airflow generated through the at least one fan 270. The air introduced into the housing 210 through the inlets 214 and 215 may be transferred to components (e.g., the at least one display 240 and/or the printed circuit board 250) in the housing 210. Heat generated in the housing 210 may be transferred to the air introduced into the housing 210. The air heated in the housing 210 may move to the at least one fan 270. As the air is discharged to the outside of the housing 210 by passing through the heat dissipation member 280 and the at least one outlet 216, the inside of the housing 210 may be cooled.

For example, as the electronic device 200 is worn by the user, the electronic device 200 may be rotated to be inclined with respect to the ground. As the electronic device 200 is rotated, a moving direction of the airflow by the at least one fan 270 from the inside of the electronic device 200 to the outside of the electronic device 200 may be changed. In a case that the moving direction of the airflow is changed, cooling efficiency by the at least one fan 270 may be reduced. Hereinafter, a structure of the electronic device 200 capable of minimizing the reduction in the cooling efficiency by the at least one fan 270 generated as the electronic device 200 is rotated with respect to the ground will be described.

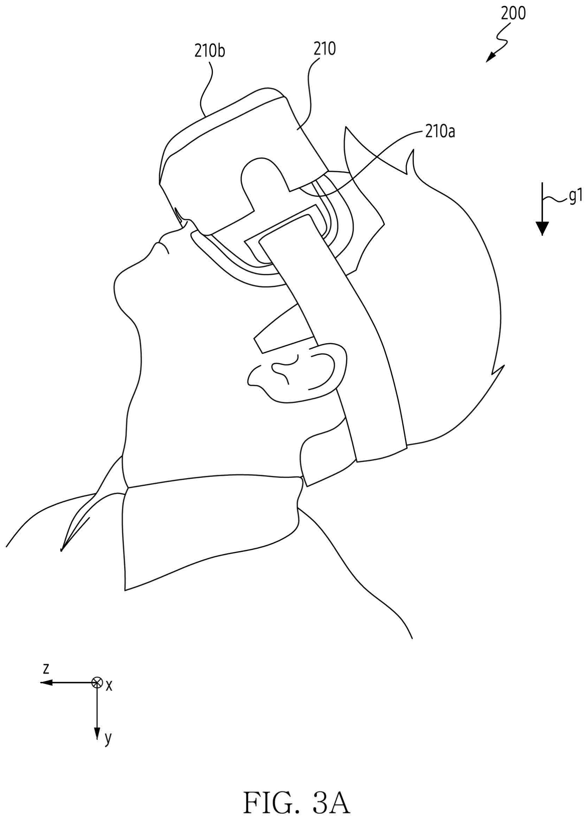

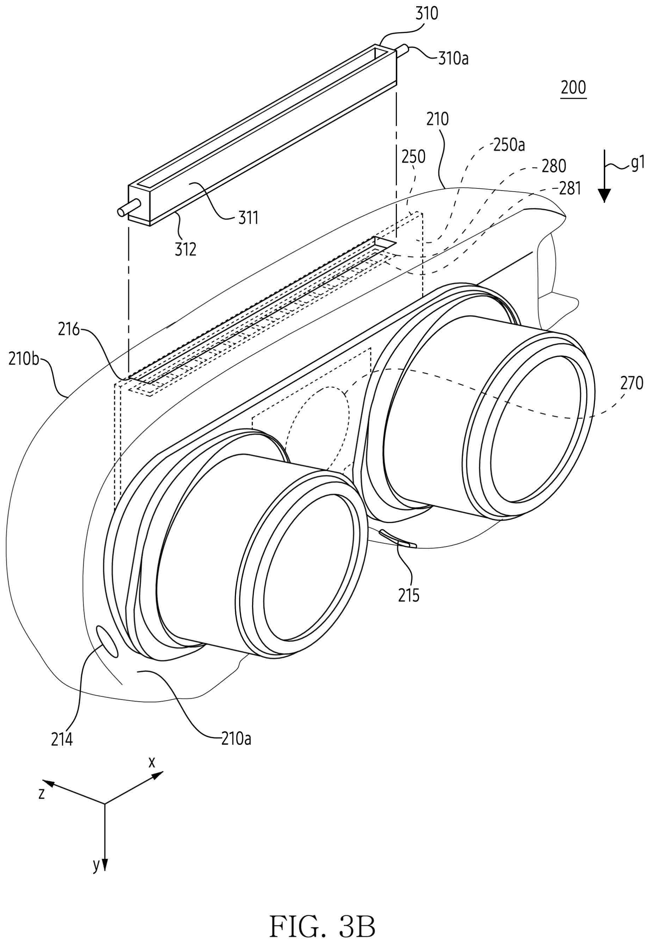

FIG. 3A indicates an example of a state in which an electronic device according to an exemplary embodiment is worn by a user, and FIG. 3B is an exploded perspective view of an electronic device according to an exemplary embodiment.

Referring to FIGS. 3A and 3B, an electronic device 200 may include a housing 210, a printed circuit board 250, at least one fan 270, a heat dissipation member 280, and/or a guide member 310.

According to an embodiment, the housing 210 may provide an outer surface of the electronic device 200. The housing 210 may surround various components of the electronic device 200. For example, the housing 210 may surround the printed circuit board 250, the at least one fan 270, the heat dissipation member 280, and/or the guide member 310. According to an embodiment, as the housing 210 is rotated, the housing 210 may be arranged in a direction different from a gravity direction g1 (e.g., a +y direction). The gravity direction g1 (e.g., the +y direction) may indicate a direction substantially perpendicular to the ground where the electronic device 200 is positioned. For example, as the housing 210 is rotated, a position of the housing 210 may change from a first position that is substantially parallel with respect to the gravity direction g1 (e.g., the +y direction) to a second position that is inclined with respect to the gravity direction g1 (e.g., the +y direction). A relationship between the housing 210 and the gravity direction g1 may be defined through surfaces 210a and 210b of the housing 210. For example, the first surface 210a and/or the second surface 210b of the housing 210 may be substantially parallel to the gravity direction g1 (e.g., the +y direction) at the first position of the housing 210. For example, the first surface 210a and/or the second surface 210b of the housing 210 may not be parallel to the gravity direction g1 (e.g., the +y direction) at the second position of the housing 210. For example, the first surface 210a and/or the second surface 210b of the housing 210 may be inclined with respect to the gravity direction g1 (e.g., the +y direction) at the second position of the housing 210.

According to an embodiment, the housing 210 may include at least one first inlet 214, at least one second inlet 215, and/or at least one outlet 216. The at least one first inlet 214 and the at least one second inlet 215 may connect the outside of the housing 210 to the inside of the housing 210. The at least one first inlet 214 and the at least one second inlet 215 may provide (or form) a path through which air from the outside of the housing 210 may move into the inside of the housing 210. For example, one of the at least one first inlet 214 and the at least one second inlet 215 may be omitted. The at least one outlet 216 may connect the inside of the housing 210 and the outside of the housing 210. The at least one outlet 216 may provide a path through which air from the inside of the housing 210 may move to the outside of the housing 210. For example, the at least one outlet 216 may provide the path for air moving from the inside of the housing 210 to the outside of the housing 210 by the at least one fan 270.

According to an embodiment, the printed circuit board 250 may be accommodated in the housing 210. The printed circuit board 250 may be fastened in the housing 210, but it is not limited thereto. For example, the printed circuit board 250 may be fastened in the housing 210 by a fastening member (e.g., a screw). As the printed circuit board 250 is fastened in the housing 210, a position of the printed circuit board 250 with respect to the housing 210 may not be changed by movement of the housing 210. The position of the printed circuit board 250 with respect to the housing 210 may be maintained (or fixed) while the housing 210 is moving. As the printed circuit board 250 is fastened in the housing 210, the printed circuit board 250 may move together with the housing 210 when the housing 210 moves. According to an embodiment, the printed circuit board 250 may include an electronic component. The electronic component may be disposed on a surface 250a of the printed circuit board 250. For example, the electronic component may be attached on the surface 250a of the printed circuit board 250. For example, the electronic component may be contacted with the surface 250a of the printed circuit board 250.

According to an embodiment, the at least one fan 270 may be accommodated in the housing 210. The at least one fan 270 may be fastened in the housing 210. For example, the at least one fan 270 may be fastened in the housing 210 by the fastening member (e.g., the screw), but it is not limited thereto. As the at least one fan 270 is fastened in the housing 210, a position of the at least one fan 270 with respect to the housing 210 may not be changed by movement of the housing 210. The position of the at least one fan 270 with respect to the housing 210 may be maintained (or fixed) while the housing 210 is moving. As the at least one fan 270 is fastened in the housing 210, the at least one fan 270 may move together with the housing 210 when the housing 210 moves. According to an embodiment, the at least one fan 270 may be disposed on the surface 250a of the printed circuit board 250. For example, the surface 250a of the printed circuit board 250 may face the at least one fan 270. For example, the at least one fan 270 may be disposed to correspond to a portion of the surface 250a of the printed circuit board 250. According to an embodiment, the at least one fan 270 may be spaced apart from the at least one outlet 216. For example, the at least one fan 270 may be spaced apart from the at least one outlet 216 in a first direction. The first direction may be changed as the housing 210 is rotated with respect to the gravity direction g1. For example, the first direction may be substantially the same as the gravity direction g1 (e.g., the +y direction) when the housing 210 is positioned at the first position. For example, the first direction may not be parallel to the gravity direction g1 (e.g., the +y direction) when the housing 210 is positioned at the second position.

According to an embodiment, the heat dissipation member 280 may be accommodated in the housing 210. The heat dissipation member 280 may be fastened in the housing 210. For example, the heat dissipation member 280 may be fastened in the housing 210 by the fastening member (e.g., the screw), but it is not limited thereto. As the heat dissipation member 280 is fastened in the housing 210, a position of the heat dissipation member 280 with respect to the housing 210 may not be changed by movement of the housing 210. The position of the heat dissipation member 280 with respect to the housing 210 may be maintained (or fixed) while the housing 210 is moving. As the heat dissipation member 280 is fastened in the housing 210, the heat dissipation member 280 may move together with the housing 210 when the housing 210 moves. According to an embodiment, the heat dissipation member 280 may be disposed on the surface 250a of the printed circuit board 250. For example, the surface 250a of the printed circuit board 250 may face the heat dissipation member 280. For example, the heat dissipation member 280 may be disposed to correspond to another portion of the surface 250a of the printed circuit board 250. According to an embodiment, the heat dissipation member 280 may be contacted with an electronic component. For example, the heat dissipation member 280 may be attached to the electronic component. A component being attached to another component may indicate that the component is indirectly contacted with the other component through an adhesive material, in addition to being directly contacted with the other component. For example, the heat dissipation member 280 may be attached to the electronic component through an adhesive material. For example, the adhesive material may be formed of a material having high thermal conductivity.

According to an embodiment, the heat dissipation member 280 may be spaced apart from the at least one outlet 216. For example, the heat dissipation member 280 may be spaced apart from the at least one outlet 216 in the first direction. For example, the heat dissipation member 280 may be disposed between the at least one outlet 216 and the at least one fan 270, but it is not limited thereto. For example, the heat dissipation member 280 may have a shape of a heat sink including a plurality of fins 281, but it is not limited thereto. For example, the heat dissipation member 280 may have a shape of a vaporizable vapor chamber inside the heat dissipation member 280 by heat from the electronic component. In a case that the heat dissipation member 280 has the shape of the vapor chamber, a pressure inside the heat dissipation member 280 may have a pressure (e.g., a pressure in a vacuum state) lower than an atmospheric pressure.

According to an embodiment, the guide member 310 may guide movement of airflow passing through the at least one outlet 216. For example, the guide member 310 may guide the movement of the airflow so that a direction of the movement of the airflow passing through the at least one outlet 216 is parallel to the gravity direction g1 (e.g., the +y direction). The guide member 310 may be movably coupled to the housing 210. For example, the guide member 310 may be coupled to the housing 210 so as to be independently rotatable with respect to the housing 210. A first shaft 310a of the guide member 310 may be coupled to the housing 210. For example, the first shaft 310a may penetrate the housing 210. The guide member 310 may be rotatable with respect to the housing 210 based on the first shaft 310a. The first shaft 310a may define (or provide) a rotation axis of the guide member 310. For example, a rotational direction of the guide member 310 may or may not match a rotational direction of the housing 210. According to an embodiment, at least a portion of the guide member 310 may be disposed in the at least one outlet 216. For example, a portion of the guide member 310 may be disposed inside the at least one outlet 216, and another portion of the guide member 310 may be disposed outside the at least one outlet 216. For example, the other portion of the guide member 310 may protrude to the outside of the housing 210, but it is not limited thereto. For example, an entire area of the guide member 310 may be disposed in the least one outlet 216. According to an embodiment, the guide member 310 may include a first portion 311 and/or a second portion 312. The first portion 311 and the second portion 312 may be formed of different materials. The second portion 312 may have a greater mass than the first portion 311. For example, a mass of a material forming the second portion 312 may be greater than a mass of a material forming the first portion 311. According to an embodiment, the second portion 312 may be disposed in the housing 210. The at least one fan 270 may be close to the second portion 312 among the first portion 311 and the second portion 312 of the guide member 310.

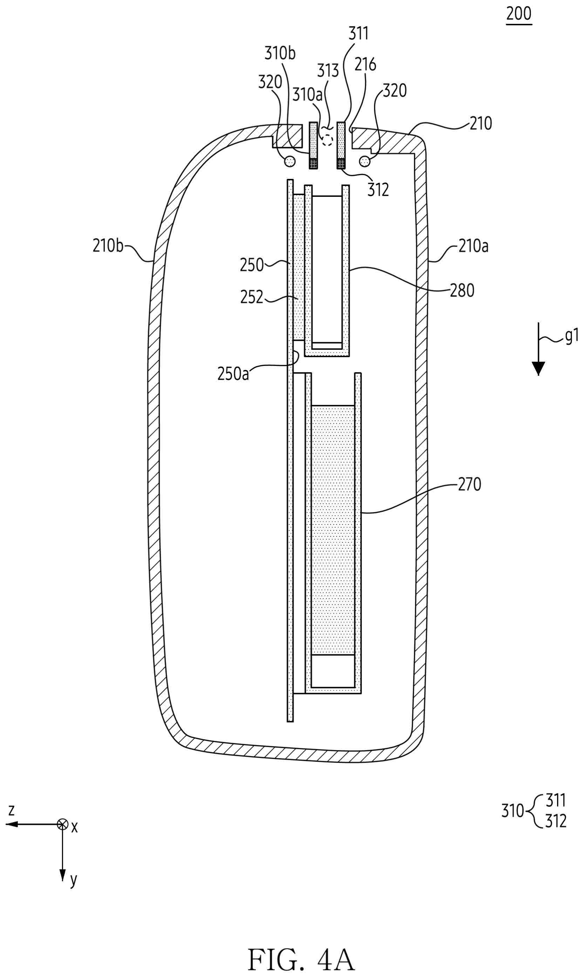

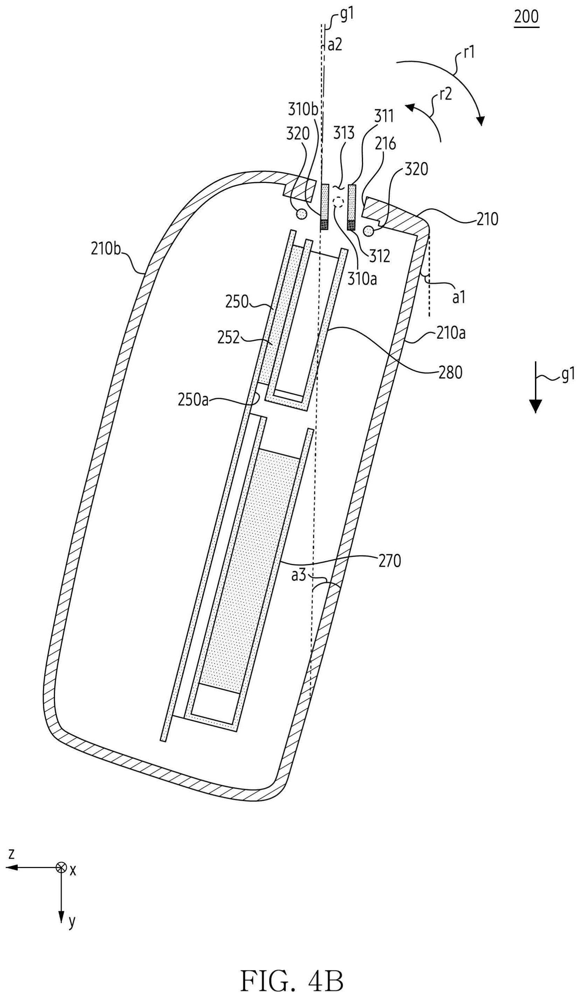

In a case that the housing 210 is rotated with respect to the gravity direction g1 (e.g., the +y direction), an angle between the at least one outlet 216 and the gravity direction g1 (e.g., the +y direction) may be changed. As the angle between the at least one outlet 216 and the gravity direction g1 (e.g., the +y direction) is changed, the movement of the airflow by the at least one fan 270 may be different. The angle between the at least one outlet 216 and the gravity direction g1 (e.g., the +y direction) being changed may be described through FIGS. 4A and 4B.

FIG. 4A is a cross-sectional view illustrating an example of cutting an electronic device according to an exemplary embodiment, and FIG. 4B is a cross-sectional view illustrating an example of cutting an electronic device according to an exemplary embodiment.

FIG. 4A may indicate when a position of a housing 210 is a first position where the housing 210 is arranged to be parallel to a gravity direction g1 (e.g., a +y direction).

FIG. 4B may indicate when the position of the housing 210 is a second position where the housing 210 is arranged not to be parallel to the gravity direction g1 (e.g., the +y direction). FIG. 4B illustrates a state in which the second position of the housing 210 is rotated clockwise from the first position of the housing 210 with respect to the gravity direction g1 (e.g., the +y direction), but it is not limited thereto. For example, the second position of the housing 210 may indicate a state rotated counterclockwise from the first position of the housing 210.

Referring to FIGS. 4A and 4B, according to an embodiment, an electronic component 252 may be disposed on a surface 250a of a printed circuit board 250. For example, the electronic component 252 may be attached to the surface 250a of the printed circuit board 250.

According to an embodiment, a guide member 310 may include a duct 313. The duct 313 may penetrate the guide member 310. The duct 313 may connect the inside of the housing 210 and the outside of the housing 210. The duct 313 may provide (or form) a path for air moving from the inside of the housing 210 to the outside of the housing 210 by airflow by at least one fan 270. For example, the duct 313 may penetrate a first portion 311 and a second portion 312 of the guide member 310.

According to an embodiment, the housing 210 may rotate in a first rotational direction r1 with respect to the gravity direction g1 (e.g., the +y direction). For example, the housing 210 may rotate in the first rotational direction r1 with respect to the gravity direction g1 (e.g., the +y direction) in a state of being worn by a user. When the housing 210 rotates in the first rotational direction r1, the guide member 310 may be rotatable with respect to the housing 210 in a second rotational direction r2 opposite to the first rotational direction r1. For example, when the housing 210 rotates in the first rotational direction r1, the guide member 310 may be rotatable with respect to the housing 210 in the second rotational direction r2 by a self-load of the guide member 310 (or a self-load of the second portion 312). For example, while the position of the housing 210 is changed from the first position to the second position, the guide member 310 may rotate together with the housing 210 in the first rotational direction r1 with respect to the gravity direction g1 (e.g., the +y direction). The guide member 310 may rotate in the second rotational direction r2 with respect to the housing 210 while rotating together with the housing 210 in the first rotational direction r1 with respect to the gravity direction g1 (e.g., the +y direction). As the guide member 310 rotates with respect to the housing 210 in the second rotational direction r2 opposite to the first rotational direction r1 while the housing 210 rotates with respect to the gravity direction g1 (e.g., the +y direction) in the first rotational direction r1, an angle between the duct 313 and the gravity direction g1 (e.g., the +y direction) may be reduced compared to a case in which the guide member 310 is not rotatable with respect to the housing 210 (e.g., a case in which the guide member 310 is in a fixed state to the housing 210). For example, as the guide member 310 rotates with respect to the housing 210 in the second rotational direction r2 opposite to the first rotational direction r1 while the housing 210 rotates with respect to the gravity direction g1 (e.g., the +y direction), the duct 313 may be arranged to be substantially parallel to the gravity direction g1 (e.g., the +y direction). For example, when the position of the housing 210 is the second position, a first angle a1 between the housing 210 and the gravity direction g1 (e.g., the +y direction) may be greater than a second angle a2 between the guide member 310 and the gravity direction g1 (e.g., the +y direction). The first angle a1 between the housing 210 and the gravity direction g1 (e.g., the +y direction) may indicate an angle between a first surface 210a and/or a second surface 210b of the housing 210 and the gravity direction g1 (e.g., the +y direction). The second angle a2 between the guide member 310 and the gravity direction g1 (e.g., the +y direction) may indicate an angle between a surface 310b of the guide member 310 and the gravity direction g1 (e.g., the +y direction). The surface 310b of the guide member 310 may indicate an outer surface of the guide member 310 exposed to the outside of the guide member 310. For example, the second angle a2 may be 0°, but it is not limited thereto.

Air with a relatively high temperature may move in a direction (e.g., a -y direction) opposite to the gravity direction g1 (e.g., the +y direction) by convection. In a case that the first angle a1 and the second angle a2 are substantially the same as the guide member 310 is fixed to the housing 210, movement of air in the housing 210 having a relatively high temperature to the outside may be interrupted by the guide member 310. The electronic device 200 according to an embodiment may provide a structure in which air passing through at least one outlet 216 is smooth independently of the housing 210 and the gravity direction g1 (e.g., the +y direction) since the guide member 310 is rotatable with respect to the housing 210. For example, since the guide member 310 rotates with respect to the housing 210 in the second rotational direction r2 opposite to the first rotational direction r1 while the housing 210 rotates with respect to the gravity direction g1 (e.g., the +y direction), the angle between the duct 313 and the gravity direction g1 (e.g., the +y direction) may be reduced. As the angle between the duct 313 and the gravity direction g1 (e.g., the +y direction) is reduced , the air with a relatively high temperature may be easily moved to the outside of the housing 210.

According to an embodiment, when the position of the housing 210 is the first position, a first direction, which is a direction from the at least one outlet 216 toward the at least one fan 270, may be substantially parallel to the gravity direction g1 (e.g., the +y direction). When the position of the housing 210 is changed from the first position to the second position, the first direction may not be parallel to the gravity direction g1 (e.g., the +y direction). For example, when the position of the housing 210 is the second position, the first direction may be inclined with respect to the gravity direction g1 (e.g., the +y direction). Since the guide member 310 rotates with respect to the housing 210 while the position of the housing 210 is changed from the first position to the second position, the guide member 310 may not be parallel with respect to the first direction. For example, when the position of the housing 210 is the second position, the guide member 310 may be inclined with respect to the first direction.

According to an embodiment, other components (e.g., the printed circuit board 250, the at least one fan 270, and/or a heat dissipation member 280) of the electronic device 200 other than the guide member 310 may not be rotatable with respect to the housing 210 when the housing 210 rotates in the first rotational direction r1. For example, the printed circuit board 250, the electronic component 252, the at least one fan 270, and/or the heat dissipation member 280 may rotate in the first rotational direction r1 together with the housing 210 when the housing 210 rotates in the first rotational direction r1. When the position of the housing 210 is the second position, an angle between each of the printed circuit board 250, the electronic component 252, the at least one fan 270, and the heat dissipation member 280 and the gravity direction g1 (e.g., the +y direction) may be substantially the same as the first angle a1 between the housing 210 and the gravity direction g1 (e.g., the +y direction).

According to an embodiment, a stopper 320 may limit a rotation angle of the guide member 310. For example, as the guide member 310 rotates with respect to the housing 210, the stopper 320 may suppress blocking the at least one outlet 216. According to an embodiment, the stopper 320 may be disposed in the housing 210. The guide member 310 may be spaced apart from the stopper 320 while rotating with respect to the housing 210 within a first specified angle range. For example, the guide member 310 may not be contacted with the stopper 320 while rotating with respect to the housing 210 within the first specified angle range. The first specified angle range may be defined as a third angle a3 between the surface 310b of the guide member 310 and the first surface 210a of the housing 210. For example, the guide member 310 may be spaced apart from the stopper 320 while the third angle a3 between the surface 310b of the guide member 310 and the first surface 210a of the housing 210 is within the first specified angle range. For example, the first specified angle range may be approximately 0° to 50°. The guide member 310 may be contacted with the stopper 320 when rotating with respect to the housing 210 outside the first specified angle range. For example, the guide member 310 may be contacted with the stopper 320 when the third angle a3 between the surface 310b of the guide member 310 and the first surface 210a of the housing 210is outside the first specified angle range. As a rotation range of the guide member 310 with respect to the housing 210 is limited by the stopper 320, it may be suppressed that the guide member 310 blocks the at least one outlet 216. For example, in a case that the rotation range of the guide member 310 is not limited by the stopper 320, the surface 310b of the guide member 310 may face the heat dissipation member 280 by rotation of the guide member 310. In a case that the surface 310b of the guide member 310 faces the heat dissipation member 280, movement of air through the at least one outlet 216 may be limited. The electronic device 200 according to an embodiment may provide a structure in which air moves smoothly through the at least one outlet 216 by the stopper 320 limiting the rotation range of the guide member 310.

As described above, the electronic device 200 according to an embodiment may provide a structure in which the angle between the duct 313 and the gravity direction g1 (e.g., +y direction) is relatively small by the guide member 310 rotatable in the second rotational direction r2 opposite to the first rotational direction r1 of the housing 210.

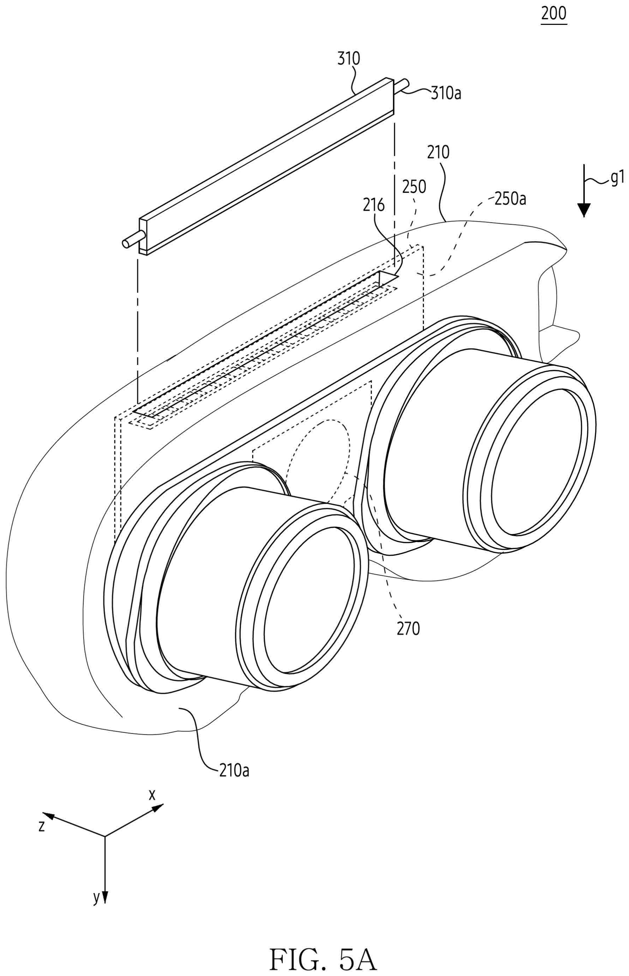

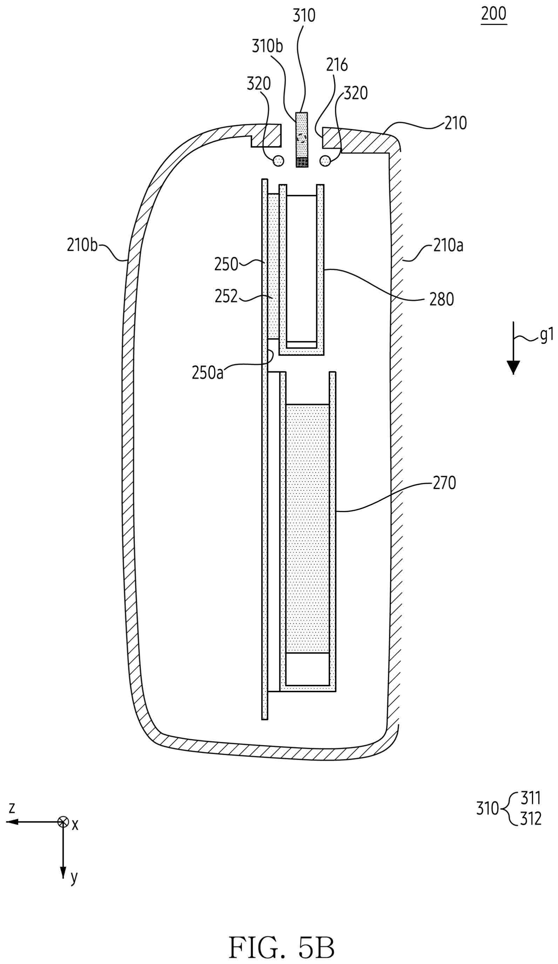

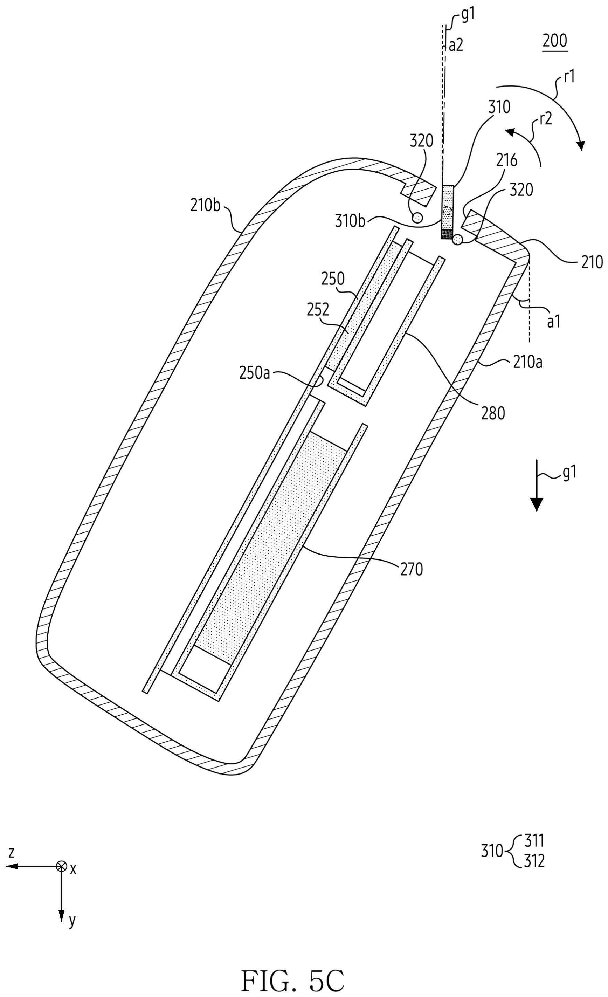

FIG. 5A is an exploded perspective view of an electronic device according to an exemplary embodiment, FIG. 5B is a cross-sectional view illustrating an example of cutting an electronic device according to an exemplary embodiment, and FIG. 5C is a cross-sectional view illustrating an example of cutting an electronic device according to an exemplary embodiment.

Since an electronic device 200 of FIGS. 5A, 5B, and 5C may be the electronic device 200 in which a shape of a guide member 310 is changed in the electronic device 200 of FIGS. 3A and 3B, a redundant description thereof will be omitted.

FIG. 5B may indicate when a position of a housing 210 is a first position where the housing 210 is arranged to be parallel to a gravity direction g1 (e.g., a +y direction).

FIG. 5C may indicate when the position of the housing 210 is a second position where the housing 210 is arranged not to be parallel to the gravity direction g1 (e.g., the +y direction). FIG. 5C illustrates a state in which the second position of the housing 210 is rotated clockwise from the first position of the housing 210 with respect to the gravity direction g1 (e.g., the +y direction), but it is not limited thereto. For example, the second position of the housing 210 may indicate a state rotated counterclockwise from the first position of the housing 210.

Referring to FIG. 5A, according to an embodiment, a size of the guide member 310 may be smaller than a size of at least one outlet 216. For example, a width of the guide member 310 may be smaller than a width of the at least one outlet 216. A width of a component may indicate a distance (e.g., a -z direction) in a direction parallel to a direction (e.g., a -z direction or a +z direction) in which a first surface 210a faces when the position of the housing 210 is the first position. For example, the guide member 310 may not include a duct (e.g., the duct 313 of FIG. 4A and FIG. 4B). For example, the guide member 310 may have a shape of a blade. Meanwhile, in FIGS. 5A, 5B, and 5C, the guide member 310 has been illustrated as including one member having the shape of the blade, but embodiments are not limited thereto. For example, the guide member 310 may include a plurality of members having the shape of the blade.

Referring to FIGS. 5B and 5C, according to an embodiment, when the position of the housing 210 is the first position, the guide member 310 may have a shape parallel to the gravity direction g1 (e.g., the +y direction). When the position of the housing 210 is the first position, the guide member 310 may have a shape parallel to a surface 250a of a printed circuit board 250. When the position of the housing 210 is the first position, the guide member 310 may be spaced apart from a stopper 320. When the position of the housing 210 is the first position, the guide member 310 may not be contacted with the stopper 320.

According to an embodiment, as the housing 210 rotates in a first rotational direction r1, the position of the housing 210 may be changed from the first position to the second position. Since the guide member 310 is coupled to the housing 210 while the position of the housing 210 is changed from the first position to the second position, the guide member 310 may rotate together with the housing 210 in the first rotational direction r1 based on a first shaft 310a. Since the guide member 310 is rotatable in a second rotational direction r2 with respect to the housing 210 while rotating together with the housing 210 in the first rotational direction r1 based on the first shaft 310a, the guide member 310 may have a shape inclined with respect to the housing 210. For example, when the position of the housing 210 is the second position, the guide member 310 may have a shape inclined in a first direction, which is a direction from the at least one outlet 216 toward at least one fan 270. Airflow from the at least one fan 270 may be discarded to the outside of the housing 210 by moving along a surface 310b of the guide member 310. For example, when the position of the housing 210 is the second position, the guide member 310 may have a shape inclined with respect to the surface 250a of the printed circuit board 250. As the guide member 310 has a shape inclined with respect to the housing 210 at the second position of the housing 210, a moving direction of the airflow passing through the at least one outlet 216 may be inclined with respect to the housing 210 by the guide member 310. For example, at the second position of the housing 210, a second angle a2 between the guide member 310 and the gravity direction g1 (e.g., the +y direction) may be smaller than a first angle a1 between the housing 210 and the gravity direction (e.g., the +y direction). As the second angle a2 is smaller than the first angle a2, the air flow through the at least one outlet 216 having a relatively high temperature may be smoothly moved.

As described above, since the second angle a2 between the guide member 310 and the gravity direction g1 (e.g., the +y direction) is smaller than the first angle a1 between the housing 210 and the gravity direction g1 (e.g., +y direction), at the second position of the housing 210, the electronic device 200 according to an embodiment may provide a structure that facilitates cooling of the electronic device 200 through the at least one fan 270.

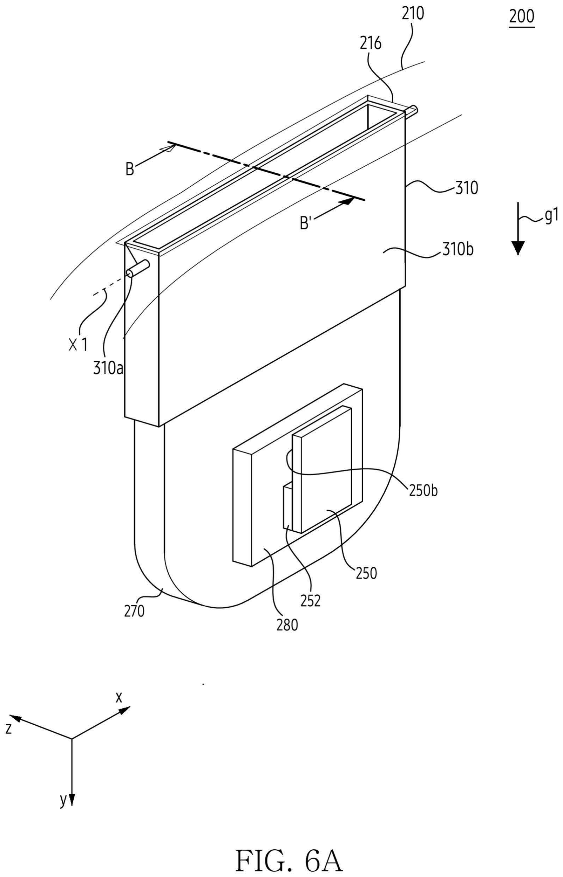

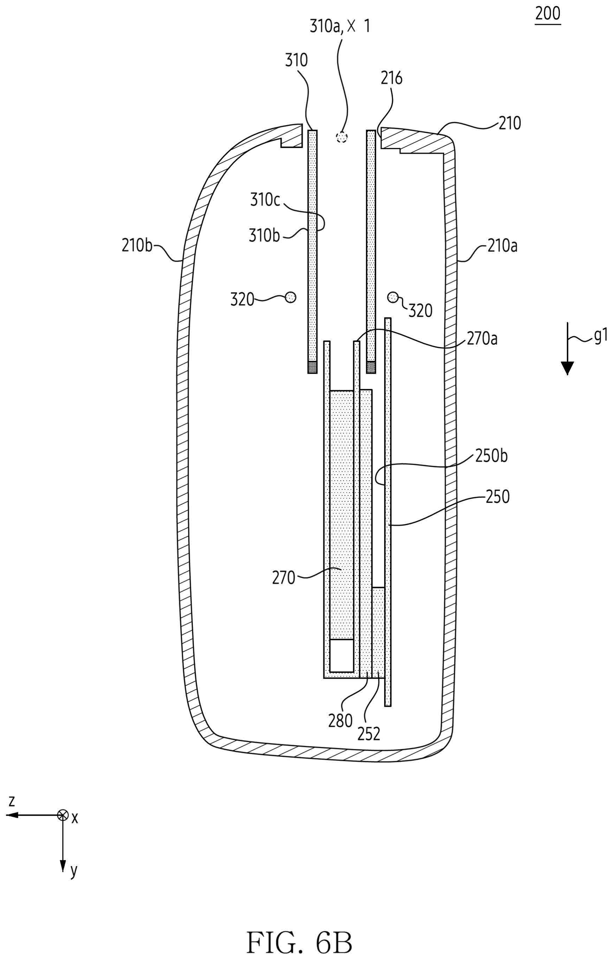

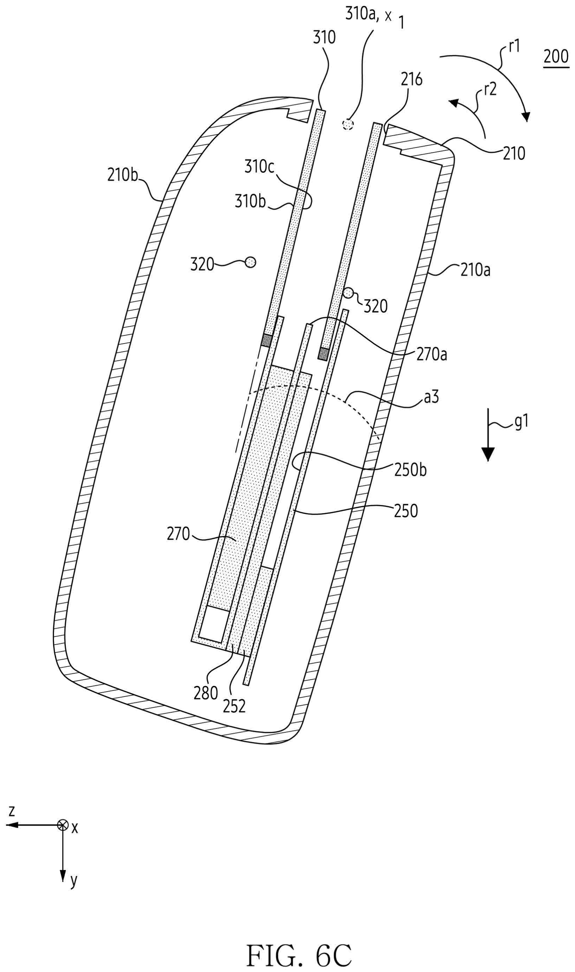

FIG. 6A is an enlarged perspective view of an electronic device according to an exemplary embodiment, FIG. 6B is a cross-sectional view illustrating an example of an electronic device according to an exemplary embodiment cut along line B-B' of FIG. 6A, and FIG. 6C is a cross-sectional view illustrating an example of cutting an electronic device according to an exemplary embodiment.

Since an electronic device 200 of FIGS. 6A, 6B, and 6C may be the electronic device 200 of which an internal structure of the electronic device 200 of FIGS. 3A and 3B is changed, a redundant description thereof will be omitted.

FIG. 6B may indicate when a position of a housing 210 is a first position where the housing 210 is arranged to be parallel to a gravity direction g1 (e.g., a +y direction).

FIG. 6C may indicate when the position of the housing 210 is a second position where the housing 210 is arranged not to be parallel to the gravity direction g1 (e.g., the +y direction). FIG. 6C illustrates a state in which the second position of the housing 210 is rotated clockwise from the first position of the housing 210 with respect to the gravity direction g1 (e.g., the +y direction), but it is not limited thereto. For example, the second position of the housing 210 may indicate a state rotated counterclockwise from the first position of the housing 210.

Referring to FIGS. 6A, 6B, and 6C, according to an embodiment, an electronic component 252 may be disposed on another surface 250b of the printed circuit board 250. The electronic component 252 may be attached to the other surface 250b of the printed circuit board 250. The other surface 250b of the printed circuit board 250 may face at least one fan 270.

According to an embodiment, a heat dissipation member 280 may be disposed on the at least one fan 270. For example, the heat dissipation member 280 may be positioned between the at least one fan 270 and the electronic component 252, and attached to the at least one fan 270. The electronic component 252 may be disposed on the heat dissipation member 280. The electronic component 252 may be attached to the heat dissipation member 280.

According to an embodiment, a guide member 310 may be rotatable with respect to the housing 210 based on a first rotation axis x1. The first rotation axis x1 may be defined (or provided) by a first shaft 310a. According to an embodiment, the guide member 310 may accommodate at least a portion of the at least one fan 270. For example, an end 270a of the at least one fan 270 may be inserted into the guide member 310.

According to an embodiment, a portion of an inner surface 310c of the guide member 310 may face the at least one fan 270. For example, the inner surface 310c of the guide member 310 may be opposite to a surface 310b of the guide member 310. For example, a direction in which the inner surface 310c of the guide member 310 faces may be opposite to a direction in which the surface 310b of the guide member 310 faces. The inner surface 310c of the guide member 310 may wrap (or surround) the end 270a of the at least one fan 270.

According to an embodiment, a stopper 320 and the at least one fan 270 may limit a rotation angle of the guide member 310. The guide member 310 may be rotatable with respect to the housing 210 within a second specified angle range smaller than a first specified angle range by the stopper 320 and the at least one fan 270. The second specified angle range may be defined as a third angle a3 between the surface 310b of the guide member 310 and a first surface 210a of the housing 210. When the third angle a3 is outside the second specified angle range, the guide member 310 may be contacted with at least one of the stopper 320 or the at least one fan 270. For example, when the third angle a3 is outside the second specified angle range, the inner surface 310c of the guide member 310 may be contacted with the at least one fan 270, or the surface 310b of the guide member 310 may be contacted with the stopper 320.

As described above, since a range of the rotation angle of the guide member 310 with respect to the housing 210 is limited by the at least one of the stopper 320 and the at least one fan 270, the electronic device 200 according to an embodiment may provide a structure in which airflow from the at least one fan 270 may be easily discharged to the outside of the housing 210.

The electronic device 200 may include at least one fan 270 for cooling the inside of the electronic device 200 by utilizing airflow. The electronic device 200 may be rotated by a user to have various angles with respect to the gravity direction. As the electronic device 200 rotates, an angle between an outlet 216 for discharging the airflow in the electronic device 200 and the gravity direction g1 may be changed. When the angle between the outlet 216 and the gravity direction g1 is changed, cooling performance by the airflow may be changed. The electronic device 200 may need a structure capable of minimizing a difference in cooling performance according to the angle between the outlet 216 and the gravity direction g1.

An electronic device (e.g., the electronic device 200 of FIG. 3A and FIG. 3B) is provided. According to an embodiment, the electronic device may comprise a housing (e.g., the housing 210 of FIG. 3A and FIG. 3B) including an inlet (e.g., the at least one first inlet 214, or the at least one second inlet 215 of FIG. 3A) and an outlet (e.g., the at least one outlet 216 of FIG. 3A and FIG. 3B) spaced apart from the inlet. According to an embodiment, the electronic device may comprise a printed circuit board (PCB) (e.g., the printed circuit board 250 of FIG. 4A and FIG. 4B) including a surface (e.g., the surface 250a of FIG. 4A and FIG. 4B) and an electronic component (e.g., the electronic component 252 of FIG. 4A and FIG. 4B) disposed on the surface. According to an embodiment, the electronic device may comprise at least one fan (e.g., the at least one fan 270 of FIG. 4A and FIG. 4B), configured to generate airflow for discharging air introduced through the inlet to the outside of the housing through the outlet, disposed in the housing for cooling the electronic component. According to an embodiment, the electronic device may comprise a guide member (e.g., the guide member 310 of FIG. 3B) configured to guide the airflow, wherein at least a portion of the guide member is disposed in the outlet. According to an embodiment, the guide member may be rotatable, when the housing is rotated in a first rotational direction, in a second rotational direction opposite to the first rotational direction.

The electronic device according to an embodiment may provide a structure in which an angle between the guide member and a gravity direction is relatively small by the guide member rotatable with respect to the housing in the second rotational direction opposite to the first rotational direction, which is a rotational direction of the housing.

According to an embodiment, the guide member may include a duct (e.g., the duct 313 of FIG. 4A and FIG. 4B), penetrating the guide member, configured to pass the airflow by the at least one fan.

The electronic device according to an embodiment may provide a structure in which an angle between the duct and the gravity direction is relatively small by the guide member rotatable with respect to the housing in the second rotational direction opposite to the first rotational direction, which is the rotational direction of the housing.

According to an embodiment, the guide member may include a first portion (e.g., the first portion 311 of FIG. 4A and FIG. 4B). According to an embodiment, the guide member may include a second portion (e.g., the second portion 312 of FIG. 4A and FIG. 4B), coupled to the first portion, having a greater mass than the first portion.

The electronic device according to an embodiment may provide the guide member rotatable in the second rotational direction by a self-load while the housing is rotated in the first rotational direction by the second portion heavier than the first portion.

According to an embodiment, the at least one fan may be closer to the second portion among the first portion and the second portion.

According to an embodiment, the electronic device may comprise a heat dissipation member (e.g., the heat dissipation member 280 of FIG. 4A and FIG. 4B), including a plurality of fins (e.g., the plurality of fins 281 of FIG. 2B), disposed between the at least one fan and the outlet, and attached to the electronic component.

The electronic device according to an embodiment may provide a structure capable of quickly dissipating heat of the electronic component to the outside of the electronic device by the heat dissipating member contacted with the electronic component.

According to an embodiment, the PCB and the at least one fan may be configured to rotate in the first rotational direction with the housing, when the housing is rotated in the first rotational direction.

According to an embodiment, the electronic device may comprise a stopper (e.g., the stopper 320 of FIG. 4A and FIG. 4B) disposed in the housing. According to an embodiment, the guide member may be spaced apart from the stopper, while rotating with respect to the housing within a specified angular range, and may be contacted with the stopper, while rotating with respect to the housing outside the specified angular range.

The electronic device according to an embodiment may provide a structure capable of suppressing the guide member from blocking the outlet by the stopper limiting a rotation range of the guide member.

According to an embodiment, the housing may include a first surface (e.g., the first surface 210a of FIG. 2A), when the electronic device is worn by a user, facing the user. According to an embodiment, the housing may include a second surface (e.g., the second surface 210b of FIG. 2A) opposite to the first surface. According to an embodiment, the housing may include a lateral surface (e.g., the lateral surface 210c of FIG. 2A) disposed between the first surface and the second surface. According to an embodiment, the inlet and the outlet may penetrate the lateral surface.

According to an embodiment, the electronic device may comprise a first display (e.g., the first display 241 of FIG. 2B), and a second display (e.g., the second display 242 of FIG. 2B) spaced apart from the first display. According to an embodiment, the electronic device may comprise a first moving flange (e.g., the first moving flange 231 of FIG. 2B), wherein a portion of the first moving flange in the housing is coupled to the first display and another portion of the first moving flange is positioned at the outside of the housing. According to an embodiment, the electronic device may comprise a second moving flange, wherein a portion of the second moving flange in the housing is coupled to the second display and another portion of the second moving flange is positioned at the outside of the housing. According to an embodiment, the first moving flange and the second moving flange may be movable with respect to the housing.

The electronic device according to an embodiment may provide a three-dimensional virtual reality to the user since moving flanges coupled to each of the displays are movable so that a distance between the displays is adjusted.

According to an embodiment, the first moving flange may include a lens (e.g., the lens 233 of FIG. 2A), coupled to the other portion of the first moving flange, facing a body of the user when the electronic device is worn by the user.

According to an embodiment, the airflow by the at least one fan may be configured to be discharged to the outside of the housing by moving along a surface of the guide member exposed to the outside of the guide member.

According to an embodiment, the electronic device may comprise a shaft (e.g., the first shaft 310a of FIG. 3B) coupled to the guide member to provide a rotation axis of the guide member.

According to an embodiment, the guide member may accommodate the at least one fan.

According to an embodiment, an inner surface of the guide member may be spaced apart from the at least one fan while rotating with respect to the housing within a specified angular range, and may be contacted with the at least one fan, while rotating with respect to the housing outside the specified angular range.

According to an embodiment, the electronic device may comprise a heat dissipation member (e.g., the heat dissipation member 280 of FIGS. 4A and 4B) attached on the at least one fan. According to an embodiment, the electronic component may be attached on the heat dissipation member.

Since the heat dissipation member is attached on the at least one fan, the electronic device according to an embodiment may provide a structure in which the at least one fan and the heat dissipation member may be rotatable with respect to the housing, by a weight of the heat dissipation member and the heat dissipation member.

According to an embodiment, the electronic device may comprise a nose pad (e.g., the nose pad 213 of FIG. 2A), when the electronic device is worn by the user, contacted with a portion of a body of the user.

An electronic device (e.g., the electronic device 200 of FIG. 3A and FIG. 3B) is provided. According to an embodiment, the electronic device may comprise a housing (e.g., the housing 210 of FIG. 3A and FIG. 3B) including an inlet (e.g., the at least one first inlet 214 of FIG. 3A) and an outlet (e.g., the at least one outlet 216 of FIG. 3A and FIG. 3B) spaced apart from the inlet. According to an embodiment, the electronic device may comprise a printed circuit board (PCB) (e.g., the printed circuit board 250 of FIG. 4A and FIG. 4B) including a surface (e.g., the surface 250a of FIG. 4A and FIG. 4B) and an electronic component (e.g., the electronic component 252 of FIG. 4A and FIG. 4B) disposed on the surface. According to an embodiment, the electronic device may comprise at least one fan (e.g., the at least one fan 270 of FIG. 4A and FIG. 4B), configured to generate airflow for discharging air introduced through the inlet to the outside of the housing through the outlet, disposed on the surface, and is spaced apart in a first direction from the outlet. According to an embodiment, the electronic device may comprise a guide member (e.g., the guide member 310 of FIG. 3B) configured to guide the airflow by being disposed in the outlet and being rotatably coupled to the housing. According to an embodiment, the guide member may be rotatable with respect to the housing so as to be inclined in the first direction when the housing rotates.

The electronic device according to an embodiment may provide a structure in which an angle between the guide member and a gravity direction is relatively small by the guide member rotatable with respect to the housing in a second rotational direction opposite to a first rotational direction, which is a rotational direction of the housing.

According to an embodiment, the guide member may include a duct (e.g., the duct 313 of FIG. 4A and FIG. 4B), penetrating the guide member, configured to pass the airflow by the at least one fan.

The electronic device according to an embodiment may provide a structure in which an angle between the duct and the gravity direction is relatively small by the guide member rotatable with respect to the housing in the second rotational direction opposite to the first rotational direction, which is the rotational direction of the housing.

According to an embodiment, the guide member may include a first portion (e.g., the first portion 311 of FIG. 4A and FIG. 4B). According to an embodiment, the guide member may include a second portion (e.g., the second portion 312 of FIG. 4A and FIG. 4B), coupled to the first portion, having a greater mass than the first portion.

The electronic device according to an embodiment may provide the guide member rotatable in the second rotational direction by a self-load while the housing is rotated in the first rotational direction by the second portion heavier than the first portion.

According to an embodiment, the guide member may accommodate the at least one fan.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a housing including an inlet and an outlet spaced apart from the inlet;
a printed circuit board (PCB) including a surface and an electronic component disposed on the surface;
at least one fan, configured to generate airflow for discharging air introduced through the inlet to outside of the housing through the outlet, disposed in the housing for cooling the electronic component; and
a guide member configured to guide the airflow, wherein at least a portion of the guide member is disposed in the outlet,
wherein the guide member is rotatable, when the housing is rotated in a first rotational direction, in a second rotational direction opposite to the first rotational direction.

2. The electronic device of claim 1,
wherein the guide member includes a duct, penetrating the guide member, configured to pass the airflow generated by the at least one fan.

3. The electronic device of any one of claim 1 or 2,
wherein the guide member includes:
a first portion, and
a second portion, coupled to the first portion, having a greater mass than the first portion.

4. The electronic device of claim 3,
wherein the at least one fan is closer to the second portion among the first portion and the second portion.

5. The electronic device of any one of claim 1 to 4, further comprising a heat dissipation member, including a plurality of fins, disposed between the at least one fan and the outlet, and attached to the electronic component.

6. The electronic device of any one of claim 1 to 5,
wherein the PCB and the at least one fan are configured to rotate in the first rotational direction with the housing, when the housing is rotated in the first rotational direction.

7. The electronic device of any one of claim 1 to 6, further comprising a stopper disposed in the housing,
wherein the guide member is spaced apart from the stopper, while rotating with respect to the housing within a specified angular range, and is contacted with the stopper, while rotating with respect to the housing outside the specified angular range.

8. The electronic device of any one of claim 1 to 7,
wherein the housing includes:
a first surface, when the electronic device is worn by a user, facing the user,
a second surface opposite to the first surface, and
a lateral surface disposed between the first surface and the second surface, and
wherein the inlet and the outlet penetrate the lateral surface.

9. The electronic device of any one of claim 1 to 8, further comprising:
a first display;
a second display spaced apart from the first display;
a first moving flange, wherein a portion of the first moving flange in the housing is coupled to the first display and another portion of the first moving flange is positioned at the outside of the housing; and
a second moving flange, wherein a portion of the second moving flange in the housing is coupled to the second display and another portion of the second moving flange is positioned at the outside of the housing, and
wherein the first moving flange and the second moving flange are movable with respect to the housing.

10. The electronic device of any one of claim 1 to 9,
wherein the airflow by the at least one fan is configured to be discharged to the outside of the housing by moving along a surface of the guide member exposed to the outside of the guide member.

11. The electronic device of any one of claim 1 to 10, further comprising a shaft coupled to the guide member to provide a rotation axis of the guide member.

12. The electronic device of any one of claim 1 to 11,
wherein the guide member accommodates the at least one fan.

13. The electronic device of claim 12,
wherein an inner surface of the guide member is spaced apart from the at least one fan while rotating with respect to the housing within a specified angular range, and is contacted with the at least one fan, while rotating with respect to the housing outside the specified angular range.

14. The electronic device of claim 12, further comprising a heat dissipation member attached on the at least one fan, and
wherein the electronic component is attached on the heat dissipation member.

15. The electronic device of any one of claim 1 to 14, further comprising a nose pad, when the electronic device is worn by a user, contacted with a portion of a body of the user.
